Europäisches Patentamt

European Patent Office

Office européen des brevets

(19)

(11) Veröffentlichungsnummer: **0 205 773**
B1

(12) **EUROPÄISCHE PATENTSCHRIFT**

(45) Veröffentlichungstag der Patentschrift:
13.12.89

(51) Int. Cl.⁴: **G01R 19/20,** G01R 21/00

(21) Anmeldenummer: 86103960.0

(22) Anmeldetag: 22.03.86

(54) Anordnung mit mindestens einem Stromwandler zur Feststellung der Ueberlastung des mindestens zwei Wicklungen besitzenden Stromwandlers.

(30) Priorität: 15.06.85 DE 3521546

(43) Veröffentlichungstag der Anmeldung:
30.12.86 Patentblatt 86/52

(45) Bekanntmachung des Hinweises auf die Patenterteilung:
13.12.89 Patentblatt 89/50

(84) Benannte Vertragsstaaten:
CH DE FR GB IT LI SE

(56) Entgegenhaltungen:
EP-A- 0 137 347
DE-A- 2 300 802
FR-A- 2 430 680
US-A- 4 027 235
US-A- 4 255 705
US-A- 4 278 940

BBC BROWN BOVERI REVIEW, Band 67, Nr. 9, September 1980, Seiten 530-534, Lucerne, CH; V. NARAYAN: "Monitoring turbogenerators in the underfrequency range"

(73) Patentinhaber: LGZ LANDIS & GYR ZUG AG,
CH-6301 Zug(CH)

(72) Erfinder: Friedl, Richard, Dr. Ing., Tiergarten 67,
D-3300 Braunschweig(DE)

(74) Vertreter: Müller, Hans-Jürgen, Dipl.-Ing. et al, Müller, Schupfner & Gauger
Lucile-Grahn-Strasse 38 Postfach 80 13 69,
D-8000 München 80(DE)

## Beschreibung

Die Erfindung bezieht sich auf eine Anordnung mit einem mindestens zwei Wicklungen aufweisenden Stromwandler der im Oberbegriff des Anspruchs 1 genannten Gattung.

Eine solche Anordnung ist bereits us der US-PS 4 255 705 bekannt. Der elektronische, mit Spitzen-Detektoren, Halteschaltungen und Summiergliedern ausgerüstete Hilfsstromkreis sorgt dafür, daß durch Gleichstromkomponenten verursachte Sättigungen des Magnetkerns des Wandlers kompensiert werden. Als Hilfswechselspannungsquelle dient hier der Lastkreis, das heißt die als zweite Wicklung auf den Magnetkern des Stromwandlers gelegte Sekundärwicklung. Nach einer anderen bekannten Ausbildung gemäß der US-A 4 278 940 wird die Hilfsspannung von einem Hallgenerator abgeleitet, welche in den Luftspalt eines zusätzlichen Magnetkerns gelegt ist, dessen Primärwicklung zur ersten bzw. Primärwicklung des Stromwandlers in Reihe geschaltet ist. Der Schaltungsaufwand und auch die Ausfallrate dieser mit elektronischen Komponenten ausgerüsteten Anordnungen befriedigen jedoch nicht.

Darüber hinaus ist es auch aus der FR-A 2 430 680 bekannt, einen Stromwandler mit zwei Wicklungen auszurüsten, um Fehlerströme zu ermitteln, die im Falle von Erdungsfehlern auftreten.

In Elektrizitätszählern mit eingebauten Stromwandlern ist oft die Feststellung von Meßfehlern infolge von Überlastungen der Magnetkerne der Stromwandler erwünscht. Mit dem Aufkommen elektronischer statischer Elektrizitätszähler stellt sich mehr und mehr die Frage nach deren Zuverlässigkeit ohne Wartung über Jahrzehnte hinweg. Da die Ausfallraten dieser Elektrizitätszähler etwa proportional der Anzahl der elektronischen Bauelemente sind, gilt es, für die Meßwertbildung so wenig elektronische Komponenten wie möglich zu verwenden. Für die Erfassung der Meßstromstärke werden dabei für die Weiterverarbeitung im Elektrizitätszähler Stromwandler oder Shunts eingesetzt. Die Anwendung von Shunts ist aber praktisch nur bei Einphasen-Wechselstromzählern sinnvoll. Bei Drehstromzählern erweist sich die galvanische Trennung der Stromkreise voneinander als notwendig, so daß man ohne Stromwandler nicht auskommt. Dabei ergibt sich nun das Problem, daß Überstromstärken und Gleichstromanteile im Verbraucherstrom – beispielsweise durch Einweggleichrichtung – zu magnetischen Sättigungserscheinungen, d.h. zu Überlastungen, im Wandlerkern und damit zu mehr oder weniger großen Minusfehlern bei der Energieverbrauchsbestimmung führen. Es gibt sogenannte aktive Stromwandler mit elektronischen Hilfsstromkreisen, die dafür sorgen, daß eine Sättigung der Wandlerkerne vermieden wird. Sie haben den Nachteil, daß sie den Schaltungsaufwand des elektronischen Elektrizitätszählers vergrößern, wodurch die Ausfallrate und damit die zulässige Verwendungsdauer dieser Elektrizitätszähler verringert wird.

Wesentliche Gleichstromkomponenten im Verbraucherstromkreis von Stromkunden der Energieversorgungsunternehmen treten jedoch in der Regel nur dann auf, wenn ihre Entnahme mit der Absicht des Stromdiebstahls verbunden ist. Das heißt, sofern eine Entnahme von Gleichstromanteilen ausgeschlossen wäre, käme man mit den klassischen passiven und nahezu unbegrenzt funktionsfähigen Stromwandlern aus. Es ergibt sich daher die Frage, ob es notwendig und wirtschaftlich sinnvoll ist, sämtliche im Netz einzubauenden statischen Elektrizitätszähler mit den relativ aufwendigen, die Eichgültigkeitsdauer verkürzenden gleichstromunempfindlichen aktiven Stromwandlern auszurüsten oder Wege zu suchen, die sehr wenigen Kunden herauszufinden, die dem Netz wesentliche Gleichströme entnehmen.

Der Erfindung liegt die Aufgabe zugrunde, eine Anordnung zu realisieren zum Feststellen von Stromwandlerüberlastungen auf einfache Weise. Beim Einsatz in einen Elektrizitätszähler gestattet die Anordnung das Ausfindigmachen derjenigen Verbraucher elektrischer Energie, die entweder unbeabsichtigt oder vorsätzlich – beispielsweise durch Stromentnahme über Einweggleichrichter – die Verbrauchszählung der Elektrizitätszähler mehr oder weniger ausschalten.

Die genannte Aufgabe wird erfindungsgemäß durch die im Kennzeichen des Anspruchs 1 angegebenen Merkmale gelöst.

Ausführungsbeispiele der Erfindung sind in der Zeichnung dargestellt. Diese zeigt eine Anordnung zur Feststellung der Überlastung durch unmittelbare Ermittlung von Sättigungserscheinungen.

Die Anordnung enthält mindestens einen Detektor zur unmittelbaren Ermittlung von Sättigungserscheinungen in den Magnetkernen eines Stromwandlers. Diese Sättigungserscheinungen werden in einem Anzeigegerät ermittelt und angezeigt und ihre Dauer in einem Registriergerät registriert. Das Registriergerät registriert und kumuliert alle Zeiten, während denen eine Überlastung des Magnetkerns des Stromwandlers, d.h. Sättigungserscheinungen, vorhanden sind. Dies entspricht bei Verwendung des Stromwandlers in einem Elektrizitätszähler den Zeiten, während denen die Energiemessung grob fehlerhaft war.

Die Anordnung enthält einen Stromwandler 1 mit mindestens zwei gleichen geschlossenen Magnetkernen 2a und 2b. Der Stromwandler 1 besitzt mindestens eine einen primären Meßstrom $I1$ führende erste Wicklung 3 mit einer Windungszahl $W_1$ und eine einen Sekundärstrom $I2$ führende zweite Wicklung 4 mit einer Windungszahl $W_2$. Die zweite Wicklung 4 ist z.B. mittelbar oder unmittelbar mit einem Lastwiderstand $R_L$ belastet. Zusätzlich besitzt der Stromwandler 1 noch eine dritte Wicklung als Hilfswicklung 5a; 5b, die zusammen mit einer Hilfswechselspannungsquelle 8 einen Detektor bilden, wobei die Hilfswicklung 5a; 5b von der Hilfswechselspannungsquelle 8 mit einem Hilfswechselstrom $I3$ gespeist wird.

Der dargestellte Stromwandler 1 besitzt mindestens zwei annähernd gleiche geschlossene Magnetkerne 2a und 2b, die beide gemeinsam von der ersten Wicklung 3 und der zweiten Wicklung 4 umschlossen sind. Zusätzlich tragen die Magnetkerne 2a und 2b je eine annähernd gleiche dritte Wicklung 5a bzw. 5b mit den Windungszahlen $W_{31}$ bzw. $W_{32}$, wobei $W_{31} = W_{32} = W_3$. Der Windungssinn von Wicklung 5a ist dem Windungssinn der Wicklung 5b entgegengesetzt gerichtet. Für den von der Hilfswechselspannungsquelle 8 erzeugten Hilfswechselstrom $I_3$ bilden die den Hilfswechselstrom $I_3$ führenden Wicklungen 5a und 5b zwei in Reihe geschaltete gleichgroße Impedanzen, die zusammen die Hilfswicklung 5a; 5b bilden. Die von dem Hilfswechselstrom $I_3$ durch die Wicklungen 5a und 5b in den Magnetkernen 2a und 2b erzeugten magnetischen Flüsse sind entgegengesetzter Polarität aber gleichen Betrages. Diese magnetischen Flüsse induzieren somit in der zweiten Wicklung 4 gleiche Wechselspannungen jedoch mit entgegengesetzter Polarität, so daß diese sich gegenseitig aufheben und keinen Strom in der zweiten Wicklung 4 zur Folge haben. D.h., die zweite Wicklung 4 ist von der Hilfswicklung 5a; 5b magnetisch entkoppelt. Ebenso hat die erste Wicklung 3 keine magnetische Kopplung mit der Hilfswicklung 5a; 5b. Die beiden Magnetkerne 2a und 2b des Stromwandlers 1 dienen hier somit gleichzeitig als Sättigungsdetektoren und sind entsprechend beschaltet. Eine Hilfswechselspannung $U_H$ der Hilfswechselspannungsquelle 8 speist über die Reihenschaltung der beiden Wicklungen 5a und 5b, die als Hilfswicklung 5a; 5b dient, den Eingang eines nachgeschalteten Anzeigegerätes 9, dessen Ausgang mit dem Eingang des Registriergerätes 10 verbunden ist.

Der Detektor erfaßt unmittelbar die Sättigungserscheinungen in den Magnetkernen 2a und 2b des Stromwandlers 1, um sie anschließend durch das Anzeigegerät 9 anzuzeigen und/oder ihre Dauer im Registriergerät 10 zu registrieren und zu kumulieren. Die Größe des Hilfswechselstromes $I_3$ ist in beiden Anordnungen abhängig von der Impedanz der Hilfswicklung 5a; 5b und damit auch von der Permeabilität des Magnetkernmaterials, so daß Permeabilitätsänderungen insbesondere beim Auftreten von Sättigungserscheinungen im Magnetkern 2a, 2b) Änderungen des Hilfswechselstromes $I_3$ zur Folge haben, die beim Überschreiten eines vorgegebenen Schwellwertes mit an sich bekannten Mitteln, nämlich dem Anzeigegerät 9 und dem Registriergerät 10 erfaßt werden. Im normalen Betriebsfall haben die Magnetkerne 2a und 2b eine relativ hohe Permeabilität, die zu einer hohen Impedanz der Wicklungen 5a und 5b führt, so daß in diesen Wicklungen der von der Hilfswechselspannung $U_H$ getriebene Hilfswechselstrom $I_3$ relativ klein ist. Die bei Überlastung oder bei primären Gleichströmen auftretende Permeabilitätsminderung durch Sättigungserscheinungen in den Magnetkernen 2a und 2b führt zu einer Herabsetzung der Impedanzen der Wicklungen 5a und 5b und damit zu einer Erhöhung des Hilfswechselstromes $I_3$, der beim Überschreiten eines Schwellwertes z.B. ein als Anzeigegerät 9 dienendes Signal-Relais zum Ansprechen bringt, das mit Vorteil ein nachgeschalteten, als Registriergerät 10 dienenden Zeitzähler speist.

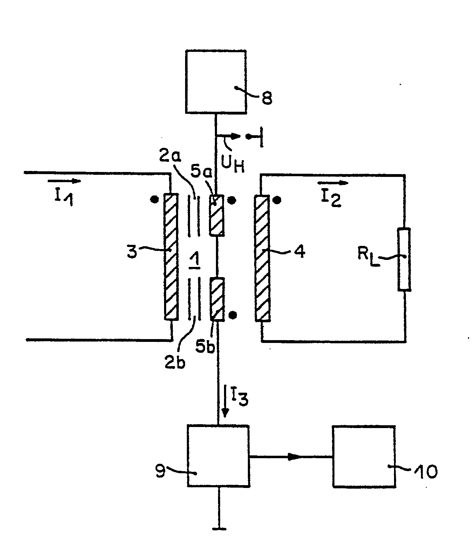

Die in der Fig. 1 dargestellte Anordnung kann in einem Einphasen-Elektrizitätszähler oder in einem Mehrphasen-Elektrizitätszähler eingesetzt werden. Im letzten Fall sind mehrere Stromwandler 1 vorhanden. Jedoch brauchen beim Vorhandensein mehrerer Stromwandler 1 die Hilfswechselspannungsquelle 8, das Anzeigegerät 9 und das Registriergerät 10 nur einmal vorhanden zu sein.

In einer ersten Variante durchfließt dann der Hilfswechselstrom $I_3$ alle Hilfswicklungen 5a; 5b der einzelnen Stromwandler 1, wobei alle diese Hilfswicklungen in Reihe geschaltet sind. Ein Überschreiten eines vorgegebenen Schwellwertes durch den Hilfswechselstrom $I_3$ betätigt dann das Anzeigegerät 9 und/oder das Registriergerät 10.

In einer zweiten Variante sind alle Hilfswicklungen 5a; 5b derart miteinander verbunden, daß der von der gemeinsamen Hilfswechselspannungsquelle 8 erzeugte Hilfswechselstrom $I_3$ den einzelnen Hilfswicklungen 5a; 5b zunächst verzweigt zugeführt wird und die Verzweigungsströme danach als Summenstrom dem Anzeigegerät 9 und/oder dem Registriergerät 10 zugeführt werden, wo beim Überschreiten eines vorgegebenen Schwellwertes durch den Summenstrom das Anzeigegerät 9 und/oder das Registriergerät 10 betätigt wird. In den beiden Varianten bilden die gemeinsame Hilfswechselspannungsquelle 8 und alle Hilfswicklungen 5a und 5b zusammen den Detektor.

Neben der reinen Anzeige und Registrierung des Fehlerfalles durch die Geräte 9 und/oder 10 ist es auch möglich, ein vom Ausgang des Detektors abgeleitetes Signal beim Überschreiten eines vorgegebenen Schwellwertes zusätzlich einem Strom- oder Spannungssignaleingang oder beiden Eingängen eines in einem Elektrizitätszähler enthaltenen Multiplizierers zuzuführen und damit wenigstens teilweise den durch Überlastung des Magnetkerns 2a; 2b entstehenden Minusfehler des Elektrizitätszählers auszugleichen.

**Patentansprüche**

1. Anordnung mit einem mindestens zwei Wicklungen (3, 4) aufweisenden Stromwandler, mit mindestens einem Detektor zur Ermittlung von Sättigungserscheinungen in mindestens einem Magnetkern (2a; 2b) des Stromwandlers, wobei der Detektor mindestens eine Hilfswicklung (5a; 5b) aufweist, die von einer Hilfswechselspannungsquelle (8) mit einem von der Permeabilität des Magnetkerns (2a; 2b) abhängigen Hilfswechselstrom ($I_3$) speisbar ist, dadurch gekennzeichnet, daß der Stromwandler (1) zur magnetischen Entkopplung der aus zwei dritten Wicklungen bestehenden Hilfswicklung (5a; 5b) von den anderen Wicklungen (3, 4) mindestens zwei annähernd gleiche Magnetkerne (2a, 2b) aufweist, die beide gemeinsam mit der ersten Wicklung (3) und der zweiten Wicklung (4) und jeweils mit einer der untereinander annähernd gleichen dritten Wicklungen versehen sind, daß die beiden dritten Wicklungen (5a, 5b) so in Reihe geschaltet sind, daß der sich durchfließende Hilfswechselstrom ($I_3$) in den beiden Magnetkernen (2a, 2b) magnetische Flüsse entgegengesetzter Polarität, aber gleichen Betrages erzeugt, während sich die durch die magnetischen Flüsse in der ersten Wicklung (3) und in der zweiten Wicklung (4) induzierten Wechselspannungen sowohl in der ersten Wicklung (3) als auch in der zweiten Wicklung (4) gegenseitig im wesentlichen aufheben, und daß die Hilfswicklung (5a, 5b) an ein Anzeige-Gerät (9) zur Anzeige von Sättigungserscheinungen in mindestens einem der Magnetkerne (2a, 2b) angeschlossen ist.

2. Anordnung nach Anspruch 1, dadurch gekennzeichnet, daß an das Anzeigegerät (9) ein Registriergerät (10) zur Registrierung und Kumulierung der Zeiten, während denen Sättigungserscheinungen im Magnetkern (2a; 2b) auftreten, angeschlossen ist.

3. Anordnung nach Anspruch 1 oder 2, dadurch gekennzeichnet, daß beim Vorhandensein mehrerer Stromwandler (1) alle Hilfswicklungen (5a; 5b) in Reihe geschaltet sind und mit einer gemeinsamen Hilfswechselspannungsquelle (8) zusammen den Detektor bilden.

4. Anordnung nach Anspruch 1 oder 2, dadurch gekennzeichnet, daß beim Vorhandensein mehrerer Stromwandler (1) alle Hilfswicklungen (5a; 5b) derart miteinander verbunden sind, daß der von einer gemeinsamen Hilfswechselspannungsquelle (8) erzeugte Hilfswechselstrom ($I_3$) den Hilfswicklungen (5a; 5b) zunächst verzweigt zugeführt wird und daß die Verzweigungsströme danach als Summenstrom dem Anzeigegerät (9) und/oder dem Registriergerät (10) zugeführt werden, wobei alle dritten Wicklungen (5a; 5b) mit der gemeinsamen Hilfswechselspannungsquelle (8) zusammen den Detektor bilden.

5. Verwendung der Anordnung nach einem der Ansprüche 1 bis 4 in einem Elektrizitätszähler zur Feststellung von Meßfehlern infolge von Überlastungen von im Elektrizitätszähler vorhandenen Stromwandlern (1).

6. Verwendung der Anordnung nach einem der Ansprüche 1 bis 4 zu dem im Anspruch 5 genannten Zweck mit der Maßgabe, daß ein vom Ausgang des Detektors abgeleitetes Signal beim Überschreiten eines vorgegebenen Schwellwertes zusätzlich einem Strom- oder Spannungssignaleingang oder beiden Eingängen eines im Elektrizitätszähler enthaltenen Multiplizierers zugeführt wird und damit wenigstens teilweise der bei Überlastung des Magnetkerns (2a; 2b) entstehende Minusfehler des Elektrizitätszählers ausgeglichen wird.

## Claims

1. An arrangement comprising a current transformer having at least two windings (3, 4), at least one detector for detecting saturation phenomena in at least one magnetic core (2a; 2b) of the current transformer, wherein the detector has at least one auxiliary winding (5a; 5b) which can be fed by an auxiliary ac voltage source (8) with an auxiliary alternating current ($I_3$) which is dependent on the permeability of the magnetic core (2a; 2b), characterised in that for magnetic decoupling of the auxiliary winding (5a; 5b) which comprises two third windings from the other windings (3, 4) the current transformer (1) has at least two approximately identical magnetic cores (2a, 2b) which are both provided jointly with the first winding (3) and the second winding (4) and with a respective one of the third windings which are approximately identical to each other, that the two third windings (5a, 5b) are so connected in series that the auxiliary alternating current ($I_3$) which flows through same produces in the two magnetic cores (2a, 2b) magnetic fluxes of opposite polarities but of the same magnitude while the ac voltages induced by the magnetic fluxes in the first winding (3) and in the second winding (4) substantially cancel each other out both in the first winding (3) and in the second winding (4) and that the auxiliary winding (5a, 5b) is connected to a display device (9) for displaying saturation phenomena in at least one of the magnetic cores (2a, 2b).

2. An arrangement according to claim 1, characterised in that connected to the display device (9) is a recording device (10) for recording and accumulating the times during which saturation phenomena occur in the magnetic core (2a; 2b).

3. An arrangement according to claim 1 or claim 2, characterised in that, when there is a plurality of current transformers (1) all auxiliary windings (5a; 5b) are connected in series and form the detector together with a common auxiliary ac voltage source (8).

4. An arrangement according to claim 1 or claim 2, characterised in that when there is a plurality of current transformers (1) all auxiliary windings (5a; 5b) are connected together in such a way that the auxiliary alternating current ($I_3$) which is produced by a common auxiliary ac voltage source (8) is initially fed to the auxiliary windings (5a; 5b) in a branched condition and that the branch currents are thereafter fed as a sum current to the display device (9) and/or the recording device (10), wherein all third windings (5a; 5b) form the detector together with the common auxiliary ac voltage source (8).

5. Use of the arrangement according to one of claims 1 to 4 in an electricity meter for detecting measurement errors as a result of overloading of current transformers (1) in the electricity meter.

6. Use of the arrangement according to one of claims 1 to 4 for the purpose set forth in claim 5 with the proviso that a signal which is derived from the output of the detector is additionally fed to a current or voltage signal input or both inputs of a multiplier included in the electricity meter, when a predetermined threshold value is exceeded, and in that way the minus error of the electricity meter which occurs upon overloading of the magnetic core (2a; 2b) is at least partially compensated.

## Revendications

1. Dispositif comprenant un transformateur de courant comportant au moins deux enroulements (3, 4), au moins un détecteur pour détecter des phénomènes de saturation dans au moins un noyau magnétique (2a; 2b) du transformateur de courant, le détecteur étant pourvu d'au moins un enroulement auxiliaire (5a; 5b), qui peut être alimenté par une source (8) de tension alternative auxiliaire avec un courant alternatif auxiliaire ($I_3$) fonction de la perméabilité du noyau magnétique (2a; 2b), caractérisé en ce que le transformateur de courant (1) comporte, pour un découplage magnétique de l'enroulement auxiliaire (5a; 5b), se composant de deux troisièmes enroulements, par rapport aux autres enroulements (3, 4), au moins deux noyaux magnétiques (2a, 2b) approximativement identiques, qui sont tous deux pourvus en commun du premier enroulement (3) et du second enroulement (4) et respectivement de l'un des troisièmes enroulements approximativement identiques entre eux, en ce que les deux troisièmes enroulements (5a, 5b) sont connectés en série de telle sorte que le courant alternatif auxiliaire ($I_3$) les parcourant produise, dans les deux noyaux magnétiques (2a, 2b), des flux magnétiques de polarités opposées mais de même grandeur tandis que les tensions alternatives induites par les flux magnétiques dans le premier enroulement (3) et dans le second enroulement (4) se contrebalancent sensiblement mutuellement aussi bien dans le premier enroulement (3) que dans le second enroulement (4) et en ce que l'enroulement auxiliaire (5a, 5b) est relié à un appareil indicateur (9) pour indiquer des phénomènes de saturation dans au moins un des noyaux magnétiques (2a, 2b).

2. Dispositif selon la revendication 1, caractérisé en ce que l'appareil indicateur (9) est relié à un appareil enregistreur (10) servant à l'enregistrement et l'accumulation des temps pendants lesquels des phénomènes de saturation se produisent dans le noyau magnétique (2a; 2b).

3. Dispositif selon une des revendications 1 ou 2, caractérisé en ce que, lors de l'existence de plusieurs transformateurs de courant (1), tous les enroulements auxiliaires (5a; 5b) sont connectés en série et constituent ensemble, et en coopération avec une source commune (8) de tension alternative auxiliaire, le détecteur.

4. Dispositif selon une des revendications 1 ou 2, caractérisé en ce que lors de l'existence de plusieurs transformateurs de courant (1), tous les enroulements auxiliaires (5a; 5b) sont reliés entre eux de telle sorte que le courant alternatif auxiliaire ($I_3$) produit par une source commune (8) de tension alternative auxiliaire soit appliqué initialement en dérivation aux enroulements auxiliaires (5a; 5b) et en ce que les courants de dérivation sont ensuite appliqués sous la forme d'un courant de sommation à l'appareil indicateur (9) et/ou à l'appareil enregistreur (10), tous les troisièmes enroulements (5a; 5b) formant ensemble, et avec la source commune (8) de tension alternative auxiliaire, le détecteur.

5. Utilisation du dispositif selon une des revendications 1 à 4 dans un compteur d'électricité pour la détermination d'erreurs de mesure par suite de surcharges de transformateurs de courant (1) se trouvant dans le compteur d'électricité.

6. Utilisation du dispositif selon une des revendications 1 à 4, dans le but précisé dans la revendication 5, avec pour fonction qu'un signal obtenu à la sortie du détecteur soit appliqué, lors du dépassement d'une valeur de seuil prédéterminée, additionnellement à une, entrée de signal d'intensité ou de signal de tension ou bien aux deux entrées d'un multiplicateur incorporé dans le compteur d'électricité et qu'ainsi la petite erreur produite dans le compteur d'électricité par suite d'une surcharge du noyau magnétique (2a; 2b) soit compensée, au moins partiellement.